# EUROPÄISCHE PATENTSCHRIFT

(11) **EP 0 392 222 B1**
(45) Veröffentlichungstag und Bekanntmachung des Hinweises auf die Patenterteilung: **03.08.1994**
(21) Anmeldenummer: 90105264.7
(22) Anmeldetag: 20.03.1990
(51) Int. Cl.: H03K 23/44

(54) **Schaltungsanordnung für einen Synchronzähler**
Synchronous counter circuit arrangement
Circuit de compteur synchrone

(30) Priorität: 11.04.1989 EP 89106358
(43) Veröffentlichungstag der Anmeldung: 17.10.1990
(73) Patentinhaber: SIEMENS AKTIENGESELLSCHAFT, 80333 München (DE)
(72) Erfinder: Preller, Peter, Dipl.-Ing., D-8000 München 60 (DE)

(56) Entgegenhaltungen:
- DE-A- 2 743 450
- FR-A- 2 267 666
- US-A- 3 829 713
- US-A- 3 833 822
- US-A- 4 025 800
- US-A- 4 395 774
- ELECTRICAL DESIGN NEWS, Band 16, Nr. 22, 15. November 1971, Seiten CH6-CH14; B.A. FETTE: "Dynamic MOS - a logical choice"
- PATENT ABSTRACTS OF JAPAN, Band 6, Nr. 32 (E-96)[910], 26. Februar 1982;& JP-A-56 153 846 (NIPPON DENKI K.K.) 28-11-1981
- PATENT ABSTRACTS OF JAPAN, Band 4, Nr. 52 (E-7)[534], 18. April 1980, Seite 120E 7; & JP-A-55 23 667 (MITSUBISHI DENKI K.K.) 20-02-1980

## Beschreibung

Die Erfindung betrifft eine Schaltungsanordnung für einen Synchronzähler mit in Reine geschalteten Zählstufen.

Es ist allgemein bekannt, daß die Zählimpulse bei Synchronzählern im Gegensatz zu den asynchronen Zählern - bei denen die Zählimpulse nur auf den Takteingang des ersten Zählflipflops gegeben werden - gleichzeitig auf alle Takteingänge wirken. Bei asynchronen Zählern besteht daher der Nachteil, daß das Eingangssignal für das letzte Zählflipflop erst ankommt, wenn alle vorhergehenden Zählflipflops umgekippt sind. Wegen ihren langen Durchlaufzeiten ist der Einsatz von Asynchronzählern aber begrenzt. Die Asynchronzähler beanspruchen im Gegensatz zum Synchronzähler jedoch eine kleinere Fläche.

Eine Schaltungsanordnung für einen Synchronzähler ist beispielsweise aus Siemens Forschungs- und Entwicklungsberichte, Band 5, 1976, Nr. 6, Seite 324 bis 326 bekannt. Dieser bekannte Synchronzähler weist in Reihe geschaltete Zählstufen mit jeweils 14 Transistoren und zwei Kapazitäten auf. Die Ausgänge der einzelnen Zählstufen sind miteinander verkoppelt, wobei jede Zählstufe zum gleichen Zeitpunkt mit einem Takt geschaltet wird. Die Lage, in die die einzelnen Zählflipflops nach jeder Taktperiode kippen, wird durch die über Kreuz geschalteten vier Transistoren bestimmt.

Ein aus der Veröffentlichung Patent Abstracts of Japan, Band 4, Nr. 52 (E-96) [534], Seite 120 E7 bekannter Synchronzähler enthält in Reihe geschaltete Zählstufen, die jeweils eine Ringschaltung aufweisen. In Abhängigkeit von der relativen Lage der Zählstufen in der Reihenschaltung hat die Ringschaltung einen unterschiedlichen Aufbau. Außerdem sind zwei Steuersignale notwendig, die parallel an alle Stufen gelegt werden.

Der vorliegenden Erfindung liegt die Aufgabe zugrunde, einen Schaltungsaufbau für einen Synchronzähler anzugeben, der im Vergleich zu den bisher bekannten Synchronzählern eine regelmäßige Struktur aufweist.

Diese Aufgabe wird dadurch gelöst, daß die Zählstufen jeweils aufweisen:
- eine erste Eingangsklemme für einen ersten Steuertakt der jeweiligen Zählstufe,
- mindestens eine erste Ausgangsklemme für ein Ausgangssignal der Zählstufe,
- eine zweite Eingangsklemme für einen zweiten Steuertakt,
- eine Taktausgangsklemme, an die die erste Eingangsklemme einer unmittelbar nachfolgenden Zählstufe anschließbar ist,
- eine Ringschaltung umfassend:
   a) eine Laststrecke eines ersten Transistors, dessen Steueranschluß mit der Eingangsklemme verbunden ist,
   b) einen ersten Inverter,
   c) eine Laststrecke eines zweiten Transistors, dessen Steueranschluß mit der zweiten Eingangsklemme verbunden ist,
   d) einen zweiten Inverter, dessen Ausgang mit der ersten Ausgangsklemme verbunden ist, und
   e) einen dritten Inverter;
- einen dritten Transistor, dessen Laststrecke zwischen die erste Eingangsklemme und die Taktausgangsklemme geschaltet ist und dessen Steueranschluß mit dem Ausgang des zweiten Inverters oder dritten Inverters verbunden ist.

Weiterbildungen der Erfindung sind Gegenstand der abhängigen Ansprüche.

Die erfindungsgemäße Schaltungsanordnung für einen Synchronzähler weist also Zählstufen auf, von denen jede eine Ringschaltung bestehend aus einer Laststrecke eines ersten Transistors, einen ersten Inverter, einer Laststrecke eines zweiten Transistors sowie einem zweiten Inverter und dritten Inverter, enthalten. Über erste und zweite Steuertakte sind diese Transistoren steuerbar. An einem Taktausgang einer Zählstufe ist jeweils der erste Steuertakt für eine unmittelbar nachfolgende Zählstufe abgreifbar, während der zweite Steuertakt an allen Zählstufen synchron anzulegen ist.

Je nach dem, ob der Steueranschluß eines dritten Transistors, der mit seiner Laststrecke zwischen die erste Eingangsklemme und Taktausgangsklemme einer Zählstufe geschaltet ist, an den Ausgang des zweiten Inverters oder dritten Inverters angeschlossen ist, ist der Synchronzähler als Vorwärts- oder Rückwärtszähler einsetzbar. Die Zählrichtung kann durch einen Umschalter einfach realisiert werden.

Gemäß einer Weiterbildung der Erfindung ist jede Zählstufe auch setzbar sowie für hohe Taktfrequenzen, bis mindestens 80 MHz, betreibbar. Damit der Synchronzähler bei solch hohen Taktfrequenzen arbeiten kann, ist es erfindungsgemäß vorgesehen, einen Carry-Übertrag durchzuführen, wenn die vorangegangenen Zählstufen an ihren Ausgängen einen H-Pegel aufweisen.

Ein wesentlicher Vorteil der erfindungsgemäßen Schaltungsanordnung liegt in deren binären Zählweise.

Die Erfindung wird im folgenden anhand von vier Figuren eingehend erläutert. Es zeigen:
- FIG 1: ein Ausführungsbeispiel einer erfindungsgemäßen Schaltungsanordnung für einen Synchronzähler mit zwei Zählstufen,
- FIG 2: ein zu FIG 1 gehörendes Impulsdiagramm,
- FIG 3: ein Ausführungsbeispiel einer erfindungsgemäßen Schaltungsanordnung nach FIG 1 mit zusätzlicher Setzmöglichkeit der Zählstufen sowie einem weiteren Transistor zur Erhöhung der Zählfrequenz und
- FIG 4: ein Ausführungsbeispiel eines erfindungsgemäßen Synchronzählers mit 8 Zählstufen und Carry-Übertrageinrichtung.

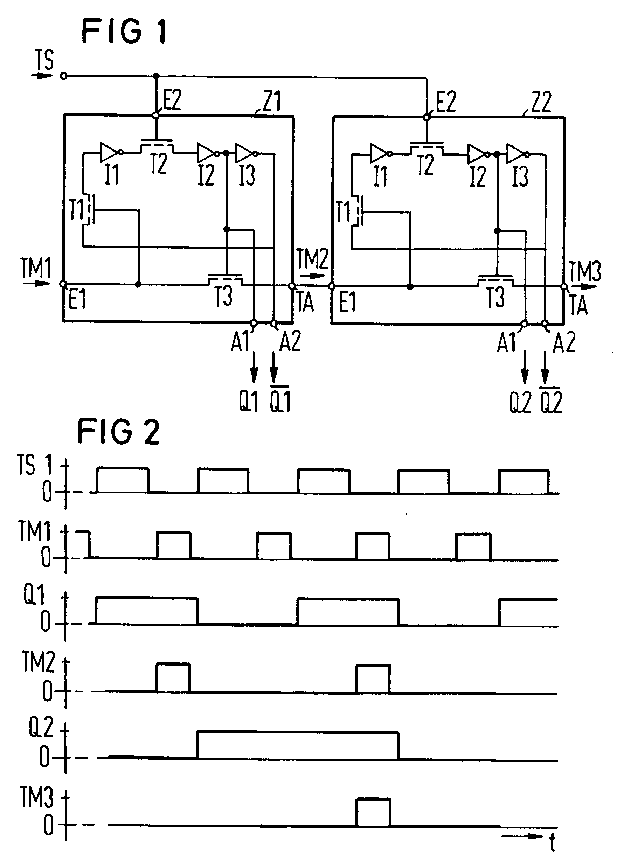

FIG 1 zeigt ein Ausführungsbeispiel einer erfindungsgemäßen Schaltungsanordnung für einen Synchronzähler mit zwei Zählstufen Z1 und Z2. Jede der beiden Zählstufen Z1, Z2 weist mindestens 4 Klemmen auf, eine erste Eingangsklemme E1, eine zweite Eingangsklemme E2, eine Taktausgangsklemme TA und eine erste Ausgangsklemme A1 für ein erstes Ausgangssignal Q1 bzw. Q2. Weiterhin ist an jeder Zählstufe Z1 und Z2 vorteilhafterweise eine zweite Ausgangsklemme A2 für ein zum Ausgangssignal Q1 bzw. Q2 invertiertes Ausgangssignal Q̅1̅ bzw. Q̅2̅ vorgesehen. An die erste Eingangsklemme E1 der ersten Zählstufe Z1 ist ein erster Steuertakt TM1, ein sogenannter Mastertakt, anlegbar. Die erste Eingangsklemme E1 der zweiten Zählstufe Z2 ist an die Taktausgangsklemme TA der ersten Zählstufe Z1 angeschlossen. Der erste Steuertakt für die zweite Zählstufe Z2 ist aus der ersten Zählstufe Z1 ableitbar und mit dem Bezugszeichen TM2 gekennzeichnet. An den zweiten Eingangsklemmen E2 der ersten und zweiten Zählstufe Z1, Z2 ist ein zweiter Steuertakt TS synchron anlegbar. Dieser zweite Steuertakt TS ist der sogenannte Slavetakt.

In jeder der Zählstufen Z1 und Z2 ist eine Ringschaltung, bestehend aus der Laststrecke eines ersten Transistors T1, einem ersten Inverter I1, einer Laststrecke eines zweiten Transistors T2, einem zweiten Inverter I2 sowie einem dritten Inverter I3 vorgesehen. Der Steueranschluß des ersten Transistors T1 ist mit der ersten Eingangsklemme E1 und die zweite Eingangsklemme E2 mit dem Steueranschluß des zweiten Transistors T2 verbunden. Die erste Ausgangsklemme A1 ist mit dem Ausgang des zweiten Inverters I2, die zweite Ausgangsklemme A2 mit dem Ausgang des dritten Inverters I3 verbunden. Weiterhin ist zwischen der ersten Eingangsklemme E1 und der Taktausgangsklemme TA die Laststrecke eines dritten Transistors T3 geschaltet. In diesem Ausführungsbeispiel sind die Steueranschlüsse der dritten Transistoren T3 der Zählstufen Z1 und Z2 mit dem Ausgang des zweiten Inverters I2 der betreffenden Zählstufe Z1, Z2 verbunden. Damit arbeitet der Synchronzähler als Vorwärtszähler.

Werden dagegen die Steueranschlüsse der dritten Transistoren T3 an den Ausgang des dazugehörenden dritten Inverters I3 gelegt, so arbeitet der Synchronzähler als Rückwärtszähler.

Für eine Zählstufe reichen insgesamt neun Transistoren aus, wenn die Inverter I1, I2 und I3 aus jeweils zwei Transistoren gebildet sind. Besonders geeignet ist die Ausführung des Synchronzählers als integrierte Schaltungsanordnung. Die Schaltungsanordnung für den Synchronzähler nach FIG 1 kann z. B. in n-Kanal-Technologie mit MOS-Transistoren realisiert sein.

Die Wirkungsweise des in FIG 1 dargestellten Synchronzählers wird anhand des Impulsdiagrammes von FIG 2 erläutert. Mit TS ist in FIG 2 der an die Eingangsklemme E2 der ersten und zweiten Zählstufe Z1, Z2 anzulegende zweite Steuertakt bezeichnet. An die erste Eingangsklemme E1 der ersten Zählstufe Z1 ist der darunter dargestellte erste Steuertakt TM1 zu sehen, der sich nicht mit dem Steuertakt TS überlappen darf, d. h. daß der erste Steuertakt TM1 nur dann positiv sein darf, wenn sich der zweite Steuertakt TS auf Low-Pegel befindet. Der Zählvorgang ist durch abwechselndes Anlegen der positiven Signale des ersten Steuertaktes TM1 und zweiten Steuertaktes TS gekennzeichnet. Der erste Steuertakt TM1 gelangt zunächst in die erste Zählstufe Z1, die nach jeder vollen Periode des zweiten Steuertaktes TS kippt. Die zweite Zählstufe Z2 bekommt den ersten Steuertakt TM2 an der ersten Eingangsklemme E1 über die erste Zählstufe Z1. Der erste Steuertakt TM2 für die zweite Zählstufe Z2 erscheint immer nur dann, wenn der Steueranschluß des dritten Transistors T3 in der ersten Zählstufe Z1 auf High-Pegel liegt. Dadurch entsteht in der zweiten Zählstufe Z2 gegenüber der ersten Zählstufe Z1 eine weitere Frequenzteilung. Das an der ersten Ausgangsklemme A1 der zweiten Zählstufe Z2 abgreifbare Ausgangssignal Q2 ist ebenfalls in FIG 2 zu sehen. An der Taktausgangsklemme TA der zweiten Zählstufe Z2 ist das erste Taktsignal TM3 für eine bei Bedarf dritte nachzuschaltende Zählstufe vorgesehen.

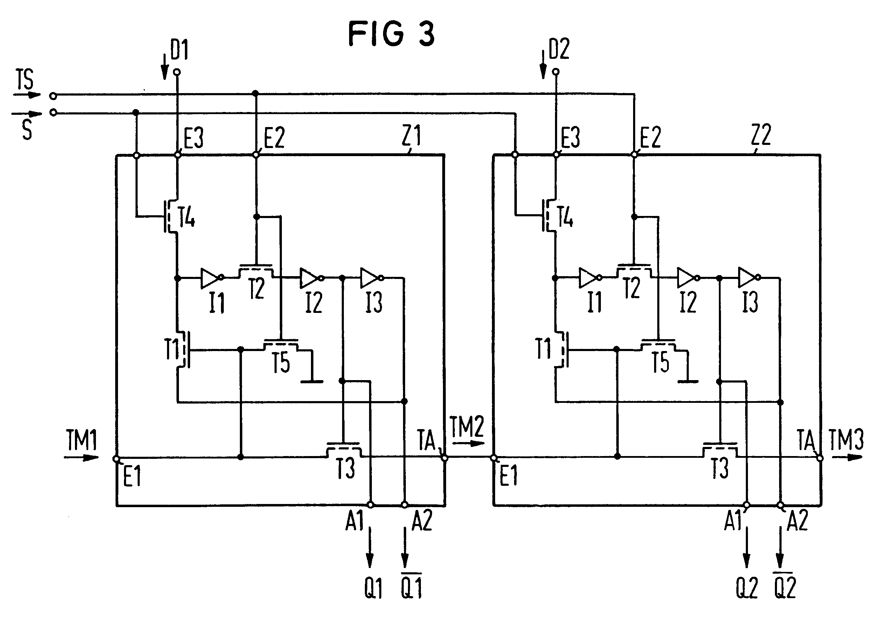

FIG 3 zeigt eine Schaltungsanordnung für einen Synchronzähler, wie dieser in FIG 2 vorgestellt wurde, jedoch mit zusätzlicher Setzmöglichkeit und einem weiteren Transistor zur Erhöhung der Zählfrequenz. Die im Zusammenhang mit FIG 2 bereits bekannten Bezugszeichen werden für gleiche Teile weiterverwendet.

Um die einzelnen Zählstufen Z1, Z2 setzen zu können, d. h. einen einen 0 oder 1 dem Ausgangssignal Q1 bzw. Q2 zu Beginn des Zählvorganges zuzuordnen, weist jede Zählstufe Z1, Z2 einen vierten Transistor T4 auf, der mit seiner Laststrecke zwischen den Verbindungspunkt des ersten Inverters I1 und dem ersten Transistor T1 und einer dritten Eingangsklemme E3, an die ein Datensignal D1 bzw. D2 anlegbar ist, geschaltet. Steuerbar sind diese vierten Transistoren T4 nach Maßgabe eines an ihre Steueranschlüsse anlegbaren Setzsignales S.

Zur Erhöhung der Taktfrequenz des Synchronzählers weist jede Zählstufe Z1, Z2 einen fünften Transistor T5 auf, dessen Steueranschluß mit der zweiten Eingangsklemme E2 verbunden und dessen Laststrecke zwischen die erste Eingangsklemme E1 und Bezugspotential geschaltet ist.

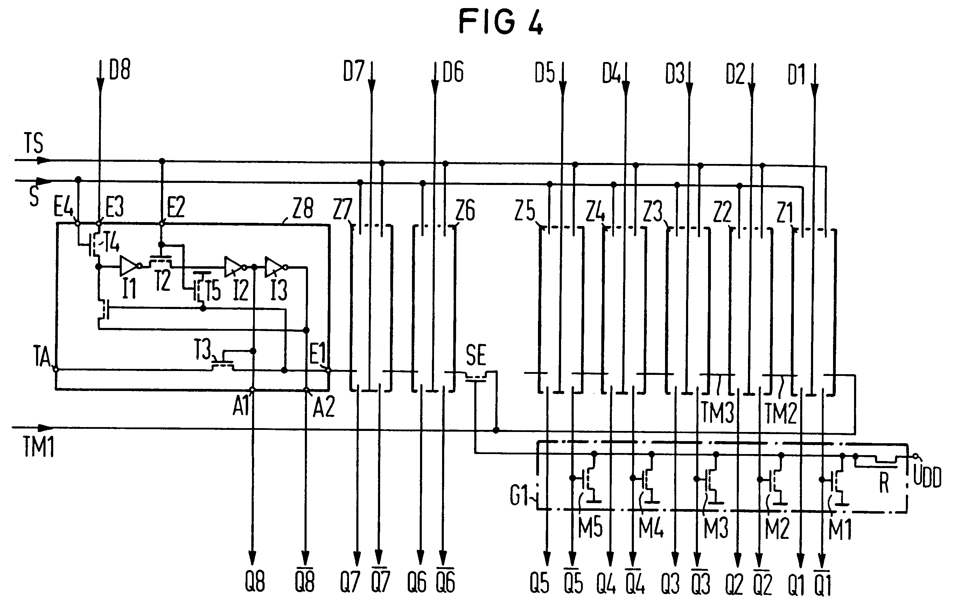

In FIG 4 ist ein Ausführungsbeispiel für einen setzbaren 8-Bit-Synchronzähler nach der Erfindung dargestellt. Die bereits bekannten Bezugszeichen werden für gleiche Teile weiterverwendet. Um eine übersichtlichere Darstellung zu gewährleisten, ist lediglich die achte Zählstufe Z8 im einzelnen gezeigt. Die Zählstufen Z1 bis Z7 sind analog aufgebaut. Jede der Zählstufen Z1 bis Z8 ist über ihre dritte Eingangsklemme E3 von einem Datensignal D1 bis D8 setzbar. Weiterhin weist das Ausführungsbeispiel eine Schalteinrichtung SE, beispielsweise in Form eines MOS-Transistors auf, der mit seiner Laststrecke beispielsweise zwischen der ersten Eingangsklemme E1 der ersten Zählstufe Z1 und der ersten Eingangsklemme E1 der sechsten Zählstufe Z6 geschaltet ist. Steuerbar ist diese Schalteinrichtung SE in Abhängigkeit der Ausgangssignale der vorangegangenen Zählstufen Z1 bis Z5.

Im einzelnen wird dazu der Steueranschluß des die Schalteinrichtung SE bildenden MOS-Transistors mit dem Ausgang eines NOR-Gatters G1 verbunden, dessen Eingänge mit den zweiten Ausgangsklemmen A2 der Zählstufen Z1 bis Z5 verbunden sind. Liegt an diesen Ausgangsklemmen A2 Low-Pegel an, d. h. daß an der ersten Ausgangsklemme A1 der Zählstufen Z1 bis Z5 logischer High-Pegel ansteht, wird der die Schalteinrichtung SE bildende MOS-Transistor durchgeschaltet und damit der an der ersten Eingangsklemme E1 der ersten Zählstufe Z1 anstehende erste Steuertakt TM1 auch an die erste Eingangsklemme E1 der sechsten Zählstufe Z6 gelegt. Damit kann der Synchronzähler mit hoher Taktfrequenz arbeiten, weil die Kette der in Reihe geschalteten dritten Transistoren T3 der Zählstufen Z1 bis Z8 unterbrochen ist. Zwischen der fünften Zählstufe Z5 und sechsten Zählstufe Z6 findet daher ein Carry-Übertrag statt, wenn die Ausgangssignale Q1 bis Q5 an den ersten Ausgangsklemmen A1 der Zählstufen Z1 bis Z5 auf High-Pegel liegen. Das NOR-Gatter G1 wird durch parallel geschaltete MOS-Transistoren M1 bis M5 gebildet, deren Source-Anschlüsse an Bezugspotential liegen und deren Drain-Anschlüsse zwischen dem Steueranschluß der Schalteinrichtung SE und einem Widerstand R liegt, der mit seinem zweiten Anschluß mit einer Spannungsquelle U_{DD} verbunden ist. Die Steueranschlüsse dieser MOS-Transistoren M1 bis M5 sind jeweils mit den Ausgangsklemmen A2 der Zählstufen Z1 bis Z5 verbunden.

Die erfindungsgemäße Schaltungsanordnung in FIG 4 für einen 8-Bit-Synchronzähler funktioniert wie folgt: Der Synchronzähler ist parallel über die an den dritten Eingangsklemmen E3 anstehenden Datensignale D1 bis D8 durch gleichzeitiges oder aufeinanderfolgendes Anlegen eines Setzsignales S an die vierten Eingangsklemmen E4 und des zweiten Steuertaktes TS an die zweiten Eingangsklemmen E2 der Zählstufen Z1 bis Z8 ladbar. Der erste Steuertakt TM1 muß dabei auf Low-Pegel bleiben. Wie eingangs erwähnt, darf sich der erste Steuertakt TM1 nicht mit dem zweiten Steuertakt TS überlappen, ebensowenig mit dem Setzsignal S. Der Zählvorgang erfolgt durch abwechselndes Anlegen des ersten Steuertaktes TM1 an die erste Zählstufe und des zweiten Steuertaktes TS. Der erste Steuertakt TM1 gelangt zunächst an die erste Zählstufe Z1, die nach jeder TM1-TS-Periode kippt. Die Zählstufe Z2 bekommt den ersten Steuertakt TM2 immer nur dann, wenn der Steueranschluß des dritten Transistors T3 in der ersten Zählstufe Z1 auf High-Pegel liegt. Dadurch entsteht in der zweiten Zählstufe Z2 gegenüber der ersten Zählstufe Z1 eine Frequenzteilung.

Der erste an der ersten Eingangsklemme E1 anliegende Steuertakt für die zweite Zählstufe Z2 ist mit TM2 bezeichnet. An der ersten Eingangsklemme E1 der dritten Zählstufe Z3 liegt ein erster Steuertakt TM3 an, der abhängig vom Schaltzustand der dritten Transistoren T3 in der ersten Zählstufe Z1 und zweiten Zählstufe Z2 ist. Damit gelangt der an der ersten Eingangsklemme E1 der ersten Zählstufe Z1 anliegende erste Steuertakt TM1 nur dann an die Eingangsklemme E1 der dritten Zählstufe Z3, wenn die dritten Transistoren T3 in der ersten Zählstufe Z1 und zweiten Zählstufe Z2 durchgesteuert sind. Bei den nachfolgenden Zählstufen gilt entsprechendes. An der Ausgangsklemme A1 der dritten Zählstufe Z3 ist damit ein Ausgangssignal Q3 abgreifbar, das nur dann schaltet, wenn die Ausgangssignale Q1 und Q2 der ersten Zählstufe Z1 und der zweiten Zählstufe Z2 auf High-Pegel liegen, so wie es gemäß der binären Zählfolge sein muß.

Es ist hier noch anzumerken, daß es vorteilhaft ist, die dritten Transistoren T3 in den Zählstufen Z1 bis Z8 derart auszuwählen, daß ihre Einsatzspannung 0 Volt beträgt. Damit wird erreicht, daß der an den Eingangsklemmen E1 der höherwertigen Zählstufen anstehende erste Steuertakt noch einen guten High-Pegel aufweist. Aus dem gleichen Grunde sollte der MOS-Transistor, der die Schalteinrichtung SE bilden kann, ein Transistor mit einer Einsatzspannung von 0 Volt sein.

Die erfindungsgemäße Schaltungsanordnung für einen Synchronzähler läßt sich auf einem Halbleiterkörper integrieren, z. B. in MOS-Technologie.

## Patentansprüche

1. Schaltungsanordnung für einen Synchronzähler mit in Reihe geschalteten Zählstufen (Z1, Z2), die jeweils aufweisen:
- eine erste Eingangsklemme (E1) für einen ersten Steuertakt (TM1, TM2) der jeweiligen Zählstufe (Z1, Z2),
- mindestens eine erste Ausgangsklemme (A1) für ein Ausgangssignal (Q1) der Zählstufe (Z1, Z2),
- eine zweite Eingangsklemme (E2) für einen zweiten Steuertakt (TS),
- eine Taktausgangsklemme (TA), an die die erste Eingangsklemme (E1) einer unmittelbar nachfolgenden Zählstufe (Z2, Z3) anschließbar ist,
- eine Ringschaltung umfassend:
a) eine Laststrecke eines ersten Transistors (T1), dessen Steueranschluß mit der Eingangsklemme (E1) verbunden ist,
b) einen ersten Inverter (I1),
c) eine Laststrecke eines zweiten Transistors (T2), dessen Steueranschluß mit der zweiten Eingangsklemme (E2) verbunden ist,
d) einen zweiten Inverter (I2), dessen Ausgang mit der ersten Ausgangsklemme (A1) verbunden ist, und
e) einen dritten Inverter (I3);
- einen dritten Transistor (T3), dessen Laststrecke zwischen die erste Eingangsklemme (E1) und die Taktausgangsklemme (TA) geschaltet ist und dessen Steueranschluß mit dem Ausgang des zweiten Inverters (I2) oder dritten Inverters (I3) verbunden ist.

2. Schaltungsanordnung nach Anspruch 1,
**dadurch gekennzeichnet,**
daß der Steueranschluß des dritten Transistors (T3) mit dem Ausgang des zweiten Inverters (I2) verbunden und der Synchronzähler dadurch als Vorwärtszähler betreibbar ist.

3. Schaltungsanordnung nach Anspruch 1,
**dadurch gekennzeichnet,**
daß der Steueranschluß des dritten Transistors (T3) mit dem Ausgang des dritten Inverters (I3) verbunden und der Synchronzähler dadurch als Rückwärtszähler betreibbar ist.

4. Schaltungsanordnung nach einem der Ansprüche 1 bis 3,
**dadurch gekennzeichnet,**
daß der Synchronzähler setzbar ausgeführt ist, indem die Zählstufen (Z1, Z2) zusätzlich einen vierten Transistor (T4) aufweisen, der mit seiner Laststrecke zwischen eine dritte Eingangsklemme (E3) und den Verbindungspunkt des ersten Inverters (I1) mit dem ersten Transistor (T1) geschaltet und dessen Steueranschluß von einem Setzsignal (S) steuerbar ist.

5. Schaltungsanordnung nach einem der Ansprüche 1 bis 4,
**dadurch gekennzeichnet,**
daß ein fünfter Transistor (T5) mit seiner Laststrecke zwischen Bezugspotential und der ersten Eingangsklemme (E1) geschaltet und dessen Steueranschluß mit der zweiten Eingangsklemme (E2) verbunden ist.

6. Schaltungsanordnung nach einem der Ansprüche 1 bis 5,
**dadurch gekennzeichnet,**
daß die erste Eingangsklemme (E1) einer höherwertigen Zählstufe (Z6) über eine Schalteinrichtung (SE) mit der ersten Eingangsklemme (E1) einer vorangegangenen Zählstufe (Z1) verbindbar ist, wenn sämtliche niederwertigen Zählstufen (Z1 bis Z5) an ihren Ausgangsklemmen (A1) einen logischen H-Pegel aufweisen.

7. Schaltungsanordnung nach Anspruch 6,
**dadurch gekennzeichnet,**
daß die Schalteinrichtung (SE) einen Transistor mit einer Einsatzspannung von 0 Volt aufweist.

8. Schaltungsanordnung nach einem der Ansprüche 1 bis 7,
**gekennzeichnet** durch die Integration auf einem Halbleiterkörper.

## Claims

1. Circuit arrangement for a synchronous counter having series-connected counting stages (Z1, Z2), each of which has:
- a first input terminal (E1) for a first control clock (TM1, TM2) of the respective counting stage (Z1, Z2),
- at least one first output terminal (A1) for an output signal (Q1) of the counting stage (Z1, Z2),
- a second input terminal (E2) for a second control clock (TS),
- a clock output terminal (TA) to which the first input terminal (E1) of an immediately following counting stage (Z2, Z3) can he connected,
- a ring circuit comprising:
a) a load path of a first transistor (T1), the control terminal of which is connected to the input terminal (E1),
b) a first inverter (I1),
c) a load path of a second transistor (T2), the control terminal of which is connected to the second input terminal (E2),
d) a second inverter (I2), the output of which is connected to the first output terminal (A1), and
e) a third inverter (I3);
- a third transistor (T3), the load path of which is connected between the first input terminal (E1) and the clock output terminal (TA), and the control terminal of which is connected to the output of the second inverter (I2) or of the third inverter (I3).

2. Circuit arrangement according to Claim 1, characterized in that the control terminal of the third transistor (T3) is connected to the output of the second inverter (I2) and the synchronous counter can consequently be operated as an upward counter.

3. Circuit arrangement according to Claim 1, characterized in that the control terminal of the third transistor (T3) is connected to the output of the third inverter (I3) and the synchronous counter can consequently be operated as a downward counter.

4. Circuit arrangement according to one of Claims 1 to 3, characterized in that the synchronous counter is designed to be settable, in that the counting stages (Z1, Z2) additionally have a fourth transistor (T4) which is connected with its load path between a third input terminal (E3) and the connection point of the first inverter (I1) and the first transistor (T1), and the control terminal of which can be controlled by a set signal (S).

5. Circuit arrangement according to one of Claims 1 to 4, characterized in that a fifth transistor (T5) is connected with its load path between reference potential and the first input terminal (E1), and the control terminal thereof is connected to the second input terminal (E2).

6. Circuit arrangement according to one of Claims 1 to 5, characterized in that the first input terminal (E1) of a higher-ranking counting stage (Z6) can be connected to the first input terminal (E1) of a preceding counting stage (Z1) via a switching device (SE) if all the lower-ranking counting stages (Z1 to Z5) have a logical H level at their output terminals (A1).

7. Circuit arrangement according to Claim 6, characterized in that the switching device (SE) has a transistor with an inception voltage of 0 volts.

8. Circuit arrangement according to one of Claims 1 to 7, characterized by the integration on a semiconductor body.

## Revendications

1. Montage pour un compteur synchrone comportant des étages de comptage (Z1, Z2) branchés en série et qui possèdent chacun :
- une première borne d'entrée (E1) pour une première cadence de commande (TM1, TM2) de l'étage respectif de comptage (Z1, Z2),
- au moins une première borne de sortie (A1) pour un signal de sortie (Q1) de l'étage de comptage (Z1, Z2),
- une seconde borne d'entrée (E2) pour une seconde cadence de commande (TS),
- une borne de sortie de cadence (TA), à laquelle peut être raccordée la première borne d'entrée (E1) d'un étage de comptage (Z2, Z3) situé directement en aval,
- un circuit en anneau comprenant :
a) une section de charge d'un premier transistor (T1), dont la borne de commande est reliée à la borne d'entrée (E1),
b) un premier inverseur (I1),
c) une section de charge d'un second transistor (T2), dont la borne de commande est reliée à la seconde borne d'entrée (E2),
d) un second inverseur (I2), dont la sortie est reliée à la première borne d'entrée (A1), et
e) un troisième inverseur (I3);
- un troisième transistor (T3), dont la section de charge est branchée entre la première borne d'entrée (E1) et la borne de sortie de cadence (TA) et dont la borne de commande est reliée à la sortie du second inverseur (I2) ou du troisième inverseur (I3).

2. Montage suivant la revendication 1, caractérisé par le fait que la borne de commande du troisième transistor (T3) est reliée à la sortie du second inverseur (I2) et que le compteur synchrone peut, de ce fait, fonctionner en tant que compteur progressif.

3. Montage suivant la revendication 1, caractérisé par le fait que la borne de commande du troisième transistor (T3) est reliée à la sortie du troisième inverseur (I3) et que le compteur synchrone peut, de ce fait, fonctionner en tant que compteur régressif.

4. Montage suivant l'une des revendications 1 à 3, caractérisé par le fait que le compteur synchrone est réalisé de manière à pouvoir être positionné, grâce au fait que les étages de comptage (Z1, Z2) comportent, en outre, un quatrième transistor (T4), dont la section de charge est branchée entre une troisième borne d'entrée (E3) et le point de jonction du premier inverseur (I1) et du premier transistor (T1) et dont la borne de commande peut être commandée par un signal de positionnement (S).

5. Montage suivant la revendication 1 à 4, caractérisé par le fait que la section de charge d'un cinquième transistor (T5) est branché entre le potentiel de référence et la première borne d'entrée (E1), tandis que sa borne de commande est reliée à la seconde borne d'entrée (E2).

6. Montage suivant l'une des revendications 1 à 5, caractérisé par le fait que la première borne d'entrée (E1) d'un étage de comptage de niveau supérieur (Z6) peut être reliée, par l'intermédiaire d'un dispositif de commutation (SE), à la première borne d'entrée (E1) d'un étage de comptage précédent (Z1), lorsque tous les étages de comptage de niveau inférieur (Z1 à Z5) délivrent un niveau logique H sur leurs bornes de sortie (A1).

7. Montage suivant la revendication 6, caractérisé par le fait que le dispositif de commutation (SE) comporte un transistor possédant une tension de déclenchement égale à 0 volt.

8. Montage suivant l'une des revendications 1 à 7, caractérisé par l'intégration sur un corps semiconducteur.
